# EUROPÄISCHE PATENTANMELDUNG

(11) **EP 3 416 462 A1**
(43) Veröffentlichungstag der Anmeldung: **19.12.2018**
(21) Anmeldenummer: 18176554.6
(22) Anmeldetag: 07.06.2018
(51) Int. Cl.: H05K 1/02, H05K 1/11, H05K 3/42

(54) **LEITERPLATTE**

(30) Priorität: 16.06.2017 AT 505062017
(71) Anmelder: ZKW Group GmbH, 3250 Wieselburg (AT)
(72) Erfinder: Edlinger, Erik, 1090 Wien (AT)
(74) Vertreter: Patentanwaltskanzlei Matschnig & Forsthuber OG

(57) **Zusammenfassung**

Eine Leiterplatte (1) mit einem Schichtaufbau, der zumindest eine erste und eine zweiten metallische Schicht (2, 3, 4, 5) sowie metallische Schichten trennende Lagen (6, 7, 8) aus einem isolierenden Verbundwerkstoff aufweist und mit mehreren metallischen Durchkontaktierungen (11..16) zwischen zumindest einer ersten und zumindest einer zweiten metallischen Schicht, wobei an zumindest einer Stelle der Leiterplatte (1) eine zentrale, durch zumindest eine Lage (7) verlaufende hülsenförmige Durchkontaktierung (17) vorgesehen ist, welche beidseitig an einer oberen und/oder unteren Endlage aus Verbundwerkstoff endet und deren zylindrischer Hohlraum (17h) mit Verbundwerkstoff gefüllt ist und an zumindest einem Ende der zentralen Durchkontaktierung in Abstand (d) von dieser zumindest zwei massive, bezüglich der zentralen hülsenförmige Durchkontaktierung (17) rotationssymmetrisch verlaufende Durchkontaktierungen (18,19) vorgesehen sind, welche mit der zentralen Durchkontaktierung in deren Endbereich in metallischer Verbindung stehen, durch eine Endlage aus Verbundwerkstoff verlaufen und bis zu einer metallischen Schicht (2; 2,5) an einer Oberfläche der Leiterplatte führen.

## Beschreibung

Die Erfindung bezieht sich auf eine Leiterplatte mit einem Schichtaufbau, der zumindest eine erste und eine zweite metallische Schicht sowie metallische Schichten trennende Lagen aus einem isolierenden Verbundwerkstoff aufweist und mit mehreren metallischen Durchkontaktierungen zwischen zumindest einer ersten und zumindest einer zweiten metallischen Schicht.

In der Elektronikindustrie werden oft mehrlagige Leiterplatten, beispielsweise FR4-Leiterplatten, verwendet, die beidseitig sehr dicht bestückt werden müssen. Möchte man nun eine solche Leiterplatte thermisch optimieren indem man thermische Durchkontaktierungen, auch "Thermal Vias" genannt, setzt, ergibt sich häufig das Problem, dass übliche Durchkontaktierungen thermisch nicht hinreichend leistungsfähig sind. Die Anordnung von Durchkontaktierungen (Vias) wird oft willkürlich, teilweise voll- bzw. halbautomatisch durchgeführt und führt oft nur zu mäßigen Resultaten hinsichtlich einer optimalen Wärmeabfuhr von elektronischen Bauelementen. Es sei angemerkt, dass derartige Durchkontaktieren natürlich auch zur elektrischen Verbindunge von Leiterbahnabschnitten in verschiedenen Lagen herangezogen werden können.

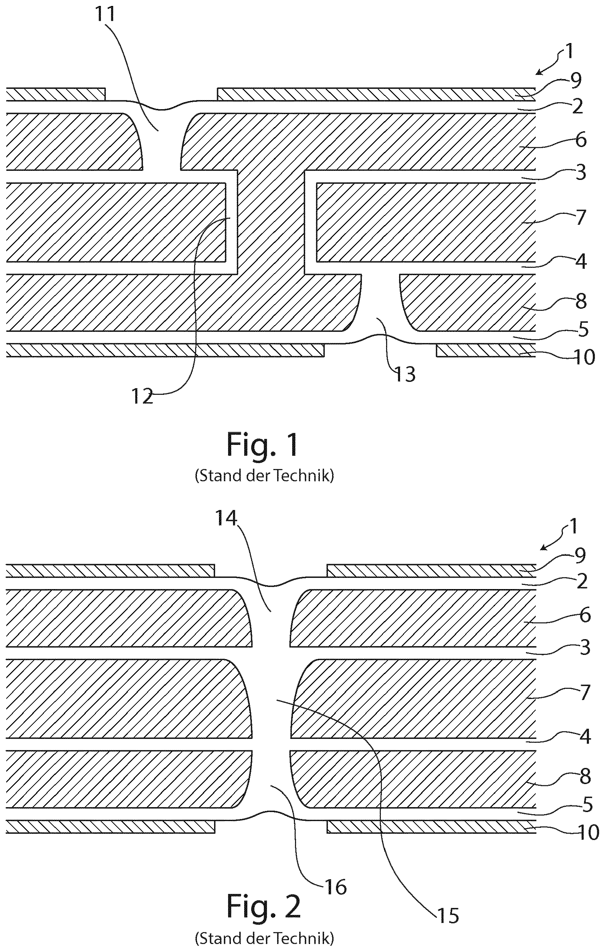

Nach dem Stand der Technik wurden Lösungen entwickelt, die oft sehr komplex und vor allem hinsichtlich ihrer Herstellung sehr kostspielig sind. Beispielsweise zeigt **Fig. 1** sogenannte "staggered Vias" wogegen **Fig. 2** eine andere Lösung, nämlich ein sogenanntes "Stack-Via" zeigt. In beiden Fällen ist eine Leiterplatte **1** gezeigt, die im vorliegenden Fall vier metallische Schichten **2, 3, 4, 5** sowie drei Lagen **6, 7, 8** aus einem isolierenden Verbundwerkstoff aufweisen. Die metallischen Schichten 2, **3, 4,** 5 bestehen üblicherweise aus Kupfer und weisen im Allgemeinen eine dem jeweiligen Einsatzzweck angepasste Strukturierung mit Leiterbahnen, Lötaugen etc. auf. Die Lagen 6, 7, 8 aus isolierendem Verbundwerkstoff trennen die metallischen Schichten und bestehen beispielsweise aus FR-4, einem Werkstoff aus Epoxidharz und Glasfasergewebe. Die äußersten Schichten, d.h. die in der Zeichnung oberste Schicht **9** bzw. unterste Schicht **10** sind zum Beispiel Schichten aus Lötstopplack.

Die metallischen Durchkontaktierungen (staggered Vias) **11, 12** und **13** der Fig. 1 verbinden die metallische Schichten 2 und 3 (Durchkontaktierung 11), die metallischen Schichten 3 und 4 (Durchkontaktierung 11) bzw. die metallischen Schichten 4 und 5, d.h. diese Durchkontaktierungen 11,12,13 sind gegeneinander versetzt ("staggered"). Die beiden Durchkontaktierungen 11 und 13 sind massive Durchkontaktierungen, die Durchkontaktierung 12 hingegen ist hülsenförmig, wobei ihr Innenraum mit dem Verbundwerkstoff gefüllt ist.

Die metallischen Durchkontaktierungen (Stack-Vias) **14, 15** und **16** der Fig. 2 hingegen verbinden übereinander gestapelt ("stacked") durchgehend alle drei metallischen Schichten 2, 3, 4.

Den metallischen Durchkontaktierungen kommt in erster Linie die Aufgabe zu, von elektronischen Bauteilen, die auf eine äußere metallische Schicht z.B. aufgelötet sind, die jedoch in Fig. 1 und 2 nicht dargestellt sind, lokal erzeugte Wärme abzuleiten, wobei auch eine elektrisch leitende Verbindung zwischen verbundenen Abschnitten der metallischen Schichten hergestellt wird.

Stack-Vias (Fig. 2) versprechen zwar thermisch eine sehr gute Leistung, jedoch befinden sich Leiterplatten mit derartigen Durchkontaktierungen preislich weit über dem Preis herkömmlicher FR4-Leiterplatten bzw. sogar über dem Preis von IMS (Insulated Metal Substrate) Leiterplatten. Staggered Vias (Fig. 1) sind preislich zwar günstiger als Stack Vias, liefern jedoch Einbußen in der thermischen Leistungsfähigkeit im Vergleich zu Stack-Vias. Um Stack-Vias zu erzeugen, muss im typischen Herstellungsprozess zwischen jeder Bohrung, die üblicherweise mit einem Laser erfolgt, ein Plating- bzw. Planarisierungsschritt eingeführt werden, der die Löcher mit Kupfer auffüllt bzw. überstehende Unebenheiten begradigt. Dies ist notwendig, da eine reflektierende Schicht vorhanden sein muss, damit der Laserstrahl nicht zu tief in das zuvor gebohrte Loch eindringt. Dies benötigt viel Prozesszeit und ist deshalb sehr kostspielig. Bei Staggered Vias kann dies ohne Plating- bzw. Planarisierungsschritt erzielt werden, da man nicht direkt auf dem bereits bestehenden Via, sondern etwas versetzt davon bohrt. Eine solche Stufenform benötigt jedoch viel Platz und hat im Vergleich zu Stack Vias eine weit schlechtere thermische Leistungsfähigkeit, da man sich mit jedem weiteren Via von jener Stelle, von welcher Wärme abgeführt werden soll ("Hotspot") entfernt, sodass lange Wege für die Wärmeableitung erzeugt werden.

Es ist eine Aufgabe der Erfindung, eine Leiterplatte mit einer Anzahl von Lagen aus einem isolierenden Verbundwerkstoff und mit mehreren thermischen, metallischen Durchkontaktierungen zu schaffen, welche einerseits eine kostengünstige Herstellung erlaubt und welche andererseits eine hohe Leistungsfähigkeit bezüglich der Wärmeableitung von kritischen Stellen (heiße Bauelemente, Hotspots) an der Oberfläche der Leiterplatte aufweist.

Diese Aufgabe wird mit einer Leiterplatte der eingangs genannten Art erreicht, bei welcher gemäß der Erfindung an zumindest einer Stelle der Leiterplatte eine zentrale, durch zumindest eine Lage verlaufende hülsenförmige Durchkontaktierung vorgesehen ist, welche beidseitig an einer oberen und/oder unteren Endlage aus Verbundwerkstoff endet und deren zylindrischer Hohlraum mit Verbundwerkstoff gefüllt ist und an zumindest einem Ende der zentralen Durchkontaktierung in Abstand von dieser zumindest zwei massive, bezüglich der zentralen hülsenförmige Durchkontaktierung rotationssymmetrisch verlaufende Durchkontaktierungen vorgesehen sind, welche mit der zentralen Durchkontaktierung in deren Endbereich in metallischer Verbindung stehen, durch eine Endlage aus Verbundwerkstoff verlaufen und bis zu einer Metalllage an einer Oberfläche der Leiterplatte führen.

Die Leiterplatte nach der Erfindung bietet auch den Vorteil, dass sich wegen der rotationssymmetrischen Anordnung der massiven Durchkontaktierungen eine gleichmäßige Wärmebelastung der Leiterplatte ergibt und die Gefahr von wärmebedingten Verwerfungen verringert wird. Außerdem kann dadurch eine besonders dichte Anordnungen der Durchkontaktierungen erreicht werden.

Falls man vorsieht, dass die massiven Durchkontaktierungen an beiden Enden der zentralen hülsenförmigen Durchkontaktierung vorgesehen sind und sowohl an der Oberseite als auch an der Unterseite der Leiterplatte durch eine Endlage aus Verbundwerkstoff verlaufen, ergibt sich eine besonders gute Wärmeabfuhr.

Dabei ist es besonders zweckmäßig, wenn die Anordnung der Durchkontaktierungen bezüglich einer Mittenebene der Leiterplatte symmetrisch ist, da eine solche Symmetrie gleichfalls die Gefahr eines Verwölbens etc. der Leiterplatte verringert.

Falls die die massiven Durchkontaktierungen von außen nach innen konisch verjüngt verlaufen, was bei Herstellung der erforderlichen Bohrungen mittels Laser der Fall ist, ist dies für das "Befüllen" der Bohrungen mit Kupfer von Vorteil.

In der Praxis ist es zweckmäßig, wenn der Durchmesser der massiven Durchkontaktierungen ein Drittel bis ein Fünftel des Durchmessers der zentralen Durchkontaktierung beträgt, da sich hierdurch eine gute Aufteilung der Wärmeleitung auf die einzelnen Durchkontaktierungen ergibt.

Zweckmäßigerweise ist der Verbundwerkstoff FR4.

Ebenso ist bevorzugter Maßen das Metall für die Durchkontaktierungen Kupfer. Dabei ist es oft zweckmäßig, wenn zumindest zwei massive Durchkontaktierungen aus Kupfer bestehen.

Besonderes wirksam sind Anordnungen, bei welchen die gegenseitigen Abstände der Durchkontaktierungen so gewählt sind, dass benachbarte zentrale Durchkontaktierungen jeweils massive Durchkontaktierungen gemeinsam haben. Auf diese Weise kann man zu optimal "dichten" Konfigurationen der Durchkontaktierungen gelangen.

Die Erfindung samt weiteren Vorteilen ist im Folgenden an Hand beispielsweiser Ausführungsformen näher erläutert, die in der Zeichnung veranschaulicht sind. In dieser zeigen
Fig. 1 und 2 zwei Ausführungen von Leiterplatten mit metallischen Durchkontaktierungen, nämlich "staggerd vias" und "stacked vias" nach dem Stand der Technik,
Fig. 3 im Schnitt eine erste Ausführungsform der Erfindung nach der Linie III-III der Fig.5,
Fig. 4 im Schnitt eine zweite Ausführungsform der Erfindung,
Fig. 5 eine Draufsicht auf einen Ausschnitt einer Leiterplatte nach der Erfindung mit vier rotationssymmetrisch um je eine zentrale Durchkontaktierung angeordneten massiven Durchkontaktierungen, wobei zur besseren Veranschaulichung die oberste Lage aus Verbundwerkstoff in der Zeichnung entfernt ist, und
Fig. 6 eine Ansicht wie Fig. 5, jedoch einer modifizierten Ausführungsform mit je sechs massiven Durchkontaktierungen.

In der folgenden Beschreibung der Erfindung werden für gleiche oder vergleichbare Elemente gleiche Bezugszeichen verwendet, um die Beschreibung und die Figuren nicht unnötig kompliziert zu gestalten.

Der Begriff "Durchkontaktierung" bedeutet nicht zwangsläufig eine Kontaktierung, sei sie thermischer und/oder elektrischer Natur, durch sämtliche Lagen einer Leiterbahn, vielmehr umfasst er auch Kontaktierungen oder Vias durch lediglich eine oder mehrere Lagen der Leiterplatte.

Begriffe hinsichtlich des Ortes oder einer Orientierung, wie beispielsweise "oben", "unten", "vorne", "darunter", "darüber" etc. werden in der Beschreibung lediglich zur Vereinfachung gewählt und beziehen sich möglicherweise auf die Darstellung in der Zeichnung nicht jedoch notwendigerweise auf eine Gebrauchs- oder Einbaulage. Insbesondere beziehen sich die Begriffe Oberseite und Unterseite in dieser Beschreibung und den Ansprüchen lediglich auf die Darstellung in der Zeichnung und sind nicht als einschränkend zu verstehen. Die Leiterplatte kann selbstverständlich auch in allen anderen möglichen Orientierungen, wie umgekehrt, stehend oder schräg verwendet bzw. in Geräte eingebaut werden.

Die Bezeichnung "elektronischer Bauteil" ist dahingehend zu verstehen, dass er sämtliche Bauteile umfassen soll, die mit Leiterbahnen in elektrischer Verbindung stehen können, wie Chips, die integrierte Schaltungen beinhalten, digitale oder analoge Prozessoren aber auch einfachere Bauelemente, wie LEDs, Widerstände und dgl.

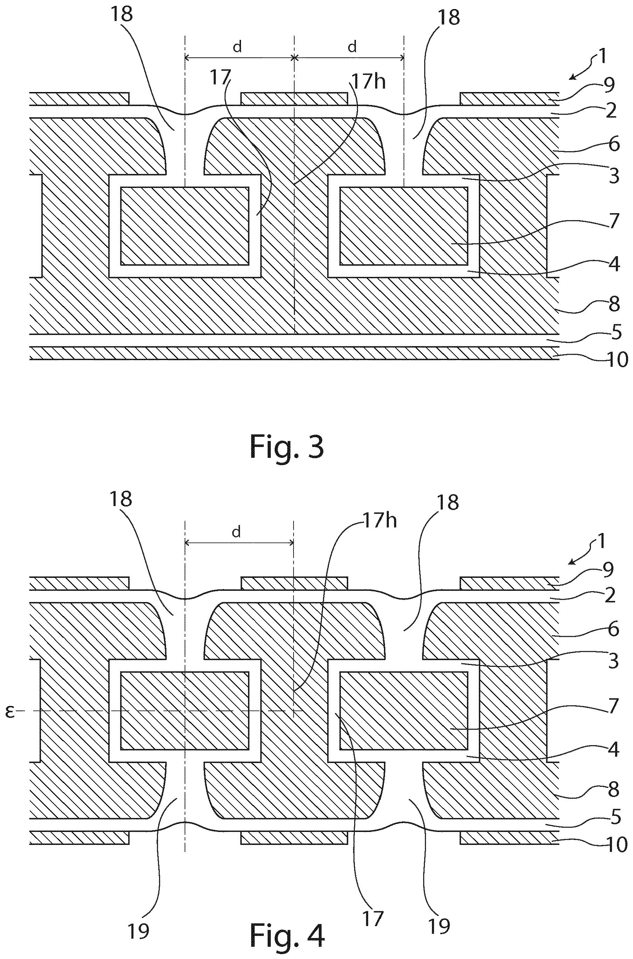

Nun auf **Fig. 3** Bezug nehmend, welche eine erste beispielsweise Ausführung der Erfindung zeigt, erkennt man eine Leiterplatte 1 mit einem Schichtenaufbau, der jenem der Fig. 1 und 2 gleicht, doch sind selbstverständlich andere Schichtenaufbauten im Rahmen der Erfindung möglich. Bei dem gezeigte Ausführungsbeispiel ist an zumindest einer Stelle der Leiterplatte 1, von welcher nur ein kleiner Abschnitt gezeigt ist, eine zentrale, durch zumindest eine Lage, hier die Lage 7, verlaufende hülsenförmige Durchkontaktierung **17** vorgesehen, welche beidseitig an einer oberen, hier an der Lage 6 und an einer unteren Lage, hier an der Lage 8, aus Verbundwerkstoff endet, wobei ihr zylindrischer Hohlraum **17h** mit Verbundwerkstoff gefüllt ist. Hier sei angemerkt, dass in bestimmten Fällen dieser Hohlraum 17h jedoch auch mit einem Metall, im Allgemeinen mit Kupfer, gefüllt sein kann.

Bei dem gezeigten Beispiel sind an dem oberen Ende der zentralen Durchkontaktierung 17 in Abstand d von dieser zumindest zwei massive Durchkontaktierungen **18** vorgesehen, welche mit der zentralen Durchkontaktierung 17 in deren oberen Endbereich über die Schicht 3 in metallischer Verbindung stehen, durch eine Endlage aus Verbundwerkstoff, nämlich die Lage 6, verlaufen und bis zu der metallischen Schicht 2 an der oberen Oberfläche der Leiterplatte 1 führen. Der oben genannte Abstand d ist hier zwischen den Achsen der Durchkontaktierungen 18 und der Achse der zentralen Durchkontaktierung 17 gemessen.

Bei der zweiten beispielsweisen Ausführungsform einer Leiterplatte 1 nach der Erfindung, von welcher ein Abschnitt in **Fig. 4** gezeigt ist, ist eine die gesamte Dicke der Leiterplatte durchsetzende Anordnung von Durchkontaktierungen vorgesehen. Bei dieser Ausführungsform ist die obere Hälfte der Ausführung nach Fig. 3 um die Mittenebene ε der Leiterplatte 1 gespiegelt, sodass insgesamt vier massive, die zentrale Durchkontaktierung in einem Abstand d umgebende massive Durchkontaktierungen vorgesehen sind, wobei die unteren, sozusagen gespiegelten Durchkontaktierungen mit **19** bezeichnet sind. Diese stehen mit der zentralen Durchkontaktierung 17 in deren unteren Endbereich über die Schicht 4 in metallischer Verbindung, verlaufen durch eine Endlage aus Verbundwerkstoff, nämlich die Lage 8, und führen bis zu der metallischen Schicht 5 an der unteren Oberfläche der Leiterplatte 1.

Was die Herstellung einer Leiterplatte nach der Erfindung betrifft, so sei als nicht einschränkende Möglichkeit genannt, dass ausgehend von einem zweilagigen Leiterplattensubstrat die zentralen Bohrungen für zentrale Durchkontaktierungen 17 mechanisch hergestellt und anschließend in einem elektrochemischen Prozess aufgekupfert, d.h. mit Kupfer befüllt werden. Danach wird durch selektives Wegätzen das Leiterplattenbild der Innenlagen abgebildet. Durch Verpressen von Prepregs wird nun auf beiden Seiten eine Harzschicht mit einer weiteren außen liegenden Kupferschicht appliziert. Durch den hohen Druck und die dabei entstehende Temperatur werden die Hohlräume in der Bohrung mit Harz verfüllt und es entsteht ein Verbund, der keinerlei Lufteinschlüsse aufweist. Durch Anwendung eines Lasers werden nun jene Bohrungen hergestellt, welche die Basis für die massiven Durchkontaktierungen 18 und 19, bilden, und die aufgrund des Laserprozesses immer auf einer planaren Kupferschicht enden müssen.

Die Herstellung von Bohrungen mittels Laserstrahlung führt in der Praxis zu konischen Bohrungen, was in den Fig. 1 bis 4 an den massiven Durchkontaktierungen deutlich zu sehen ist. Alternativ kann mit einer präzisen mechanischen Tiefenbohrung gearbeitet werden, wobei in diesem Fall die Bohrungen nicht konisch sondern zylindrisch wären. Dieser Prozess ist jedoch im Allgemeinen teuer und aufgrund der Komplexität nicht zu empfehlen. Die gebohrten Vias werden danach elektrochemisch verkupfert und im Anschluss das Leiterplattenbild der Außenlagen, wie bereits zuvor bei den Innenlagen, per Photolithographie übertragen und geätzt. Im Anschluss wird per Siebdruck der Lötstopplack und gegebenenfalls eine Beschriftungsschicht appliziert. In einem letzten Schritt kann noch die Applikation eines Metallfinish, beispielsweise eine nasschemische Galvanisierung mit Nickel und Gold erfolgen.

Bezüglich der in der Praxis verwendeten Abmessungen sollen nachstehend beispielhafte Werte angegeben werden, die jedoch ebenso wenig wie die Materialangaben als einschränkend anzusehen sind, soweit sie unter den Schutzbereich der Ansprüche fallen. Die Dicke der Prepregs, nämlich der Lagen 6, 7, 8 liegt üblicherweise zwischen 63 µm und 250 µm (Mikrometer), wobe jene der mittleren Lage 7 bevorzugt 120 µm bis 1mm beträgt. Der Durchmesser der massiven Durchkontaktierungen 18 liegt zwischen 70 µm und 300 µm, bevorzugt zwischen100 µm und 150 µm und der Durchmesser der zentralen Durchkontaktierung 17 zwischen 100 µm und 20 mm (Millimeter), bevorzugt zwischen 300 µm und 500 µm. Die Dicke der metallischen Schichten 2, 3, 4, 5, es sind üblicherweise Kupferschichten, beträgt beispielsweise 35 µm, 70 µm oder 105 µm. Die Wandstärke der zentralen Durchkontaktierung 17, somit die Dicke der Hülsenwand, liegt beispielsweise zwischen 16 µm bis 39 µm (Mikrometer).

Die Fig. 3 und 4 zeigen lediglich Schnitte durch einen kleinen Abschnitt der Leiterplatte 1. Tatsächlich ist bei praktischen Ausführungsformen in einer Leiterplatte eine Anzahl von Durchkontaktierungen in der erfindungsgemäßen Anordnung vorgesehen, was im Folgenden erläutert werden soll.

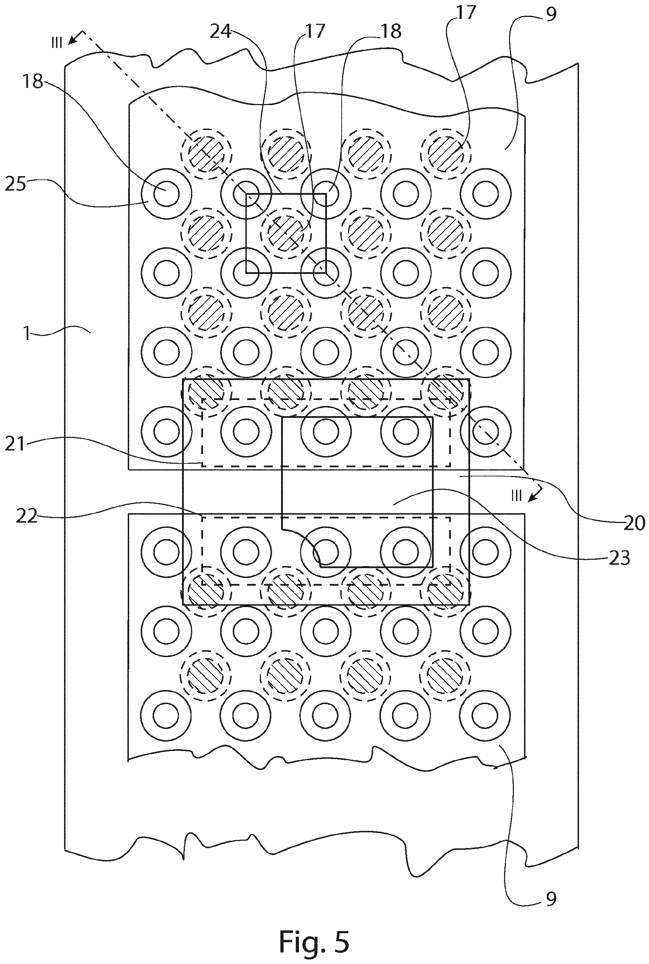

**Fig. 5** zeigt einen größeren Ausschnitt aus einer Leiterplatte 1, auf welcher ein LED-Bauteil **20** angeordnet ist. Strichliert eingezeichnet sind die Kontaktflächen (Pads) **21, 22** des Bauteils 20, mit welchen der LED-Bauteil 20 elektrisch mit Leiterbahnstrukturen der Leiterplatte 1 verbunden ist. Die Lichtemissionsfläche des LED-Bauteils 20 ist mit **23** bezeichnet.

Man erkennt in dem Abschnitt einer Leiterpatte 1 der Fig. 5 ein regelmäßiges Muster von hier zwanzig zentralen, hülsenförmigen Durchkontaktierungen 17 und zwanzig massiven Durchkontaktierungen 18. Hier sind immer vier massive Durchkontaktierungen 18 rotationssymmetrisch um je eine zentrale Durchkontaktierung 17 angeordnet, sodass Zellen **24** gebildet werden, die je aus vier massive Durchkontaktierungen 18 und einer zentralen Durchkontaktierung 17 gebildet sind. In den Draufsichten dieser und der folgenden Figur erkennt man auch Freistellungen **25** von Lötstopplack als konzentrische Kreisringe um die massiven Durchkontaktierungen 18.

In Fig. 5 erkennt man gut ein wesentliches Merkmal der Erfindung, nämlich die Anordnung je einer zentralen Durchkontaktierung 17 mit um diese herum angeordnete massive Durchkontaktierungen 18 in vorzugsweise rotationsförmiger Geometrie. Dabei ist zu beachten, dass bei der Gestaltung nach Fig. 5 die gegenseitigen Abstände der beiden Arten von Durchkontaktierungen so gewählt sind, dass benachbarte zentrale Durchkontaktierungen 17 jeweils massive Durchkontaktierungen 18 gemeinsam haben. Wären zwanzig zentralen Durchkontaktierung 17 in größerem Abstand voneinander gelegen, so ergäben sich demnach insgesamt achtzig massive Durchkontaktierungen 18 als "Satelliten".

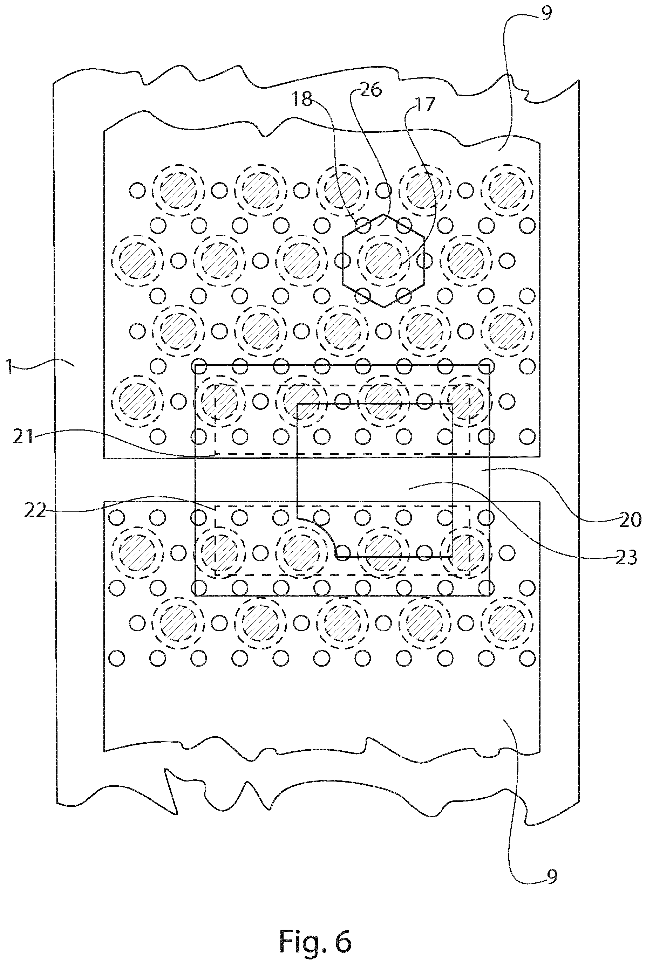

Die Darstellung nach **Fig. 6** entspricht prinzipiell jener nach Fig. 5, doch liegt hier ein hexagonales Muster vor, soll heißen eine Anordnung mit je einer zentralen Durchkontaktierung 17, um welche herum jeweils sechs massive Durchkontaktierungen 18 in rotationsförmiger Geometrie angeordnet sind. Die entsprechenden Zellen **26** sind dementsprechend hexagonal. Die massiven Durchkontaktierungen 18 weisen hier kleineren Durchmesser auf, als jene der Fig. 5. Außerdem sind in Fig. 6 keine Lötlackfreistellungen eingezeichnet. Wiederum, wie gemäß Fig. 5, sind die gegenseitigen Abstände der beiden Arten von Durchkontaktierungen so gewählt, dass benachbarte zentrale Durchkontaktierungen 17 jeweils massive Durchkontaktierungen 18 gemeinsam haben.

Lägen die Zellen in genügendem Abstand voneinander, gäbe es sechsmal so viel massive Durchkontaktierungen, wie zentrale Durchkontaktierungen.

Es hat sich gezeigt, dass ein besonders günstiges Verhältnis der Durchmesser der massiven Durchkontaktierungen 18 zu der zentralen Durchkontaktierung 17 im Wesentlichen 1:2 oder auch darüber beträgt. Im günstigsten Fall besitzt nämlich jede massive Durchkontaktierung die gleiche Wärmeleitfähigkeit, wie die zugehörige zentrale Durchkontaktierung. Dies ist annähernd dann der Fall, wenn der Querschnitt der metallischen Befüllung der massiven Durchkontaktierung die gleiche Fläche aufweist, wie die Fläche des Querschnitts der metallischen Auskleidung (Hülse) der zentralen Durchkontaktierung. Durch den größeren Radius und Umfang der zentralen Durchkontaktierung kann die Schichtdicke der Auskleidung geringer sein und dadurch auf günstigere Art hergestellt werden, beispielsweise mittels Galvanisierung.

Es versteht sich, dass im Rahmen der Erfindung unterschiedliche Anordnungen von Durchkontaktierungen auf einer Leiterplatte möglich sind, wobei im einfachsten Fall eine einzige zentrale Durchkontaktierung 17 mit z.B. drei, vier, fünf, sechs und mehr "Satelliten", d.h. massiven Durchkontaktierungen 18 vorgesehen sein kann. Fälle mit dichtesten Anordnungen sind hingegen in Fig. 5 und 6 dargestellt.

**Liste der Bezugszeichen**

| | | | |
|---|---|---|---|
| 1 | Leiterplatte | 15 | Durchkontaktierung |
| 2 | metallische Schicht | 16 | Durchkontaktierung |
| 3 | metallische Schicht | 17 | Durchkontaktierung, hülsenförmige |
| 4 | metallische Schicht | 17h | Hohlraum |
| 5 | metallische Schicht | 18 | massive Durchkontaktierung |
| 6 | Lage aus Verbundwerkstoff | 19 | massive Durchkontaktierung |
| 7 | Lage aus Verbundwerkstoff | 20 | LED-Bauteil |
| 8 | Lage aus Verbundwerkstoff | 21 | Kontaktfläche |
| 9 | oberste Schicht | 22 | Kontaktfläche |
| 10 | unterste Schicht | 23 | Lichtemissionsfläche |
| 11 | Durchkontaktierung | 24 | Zelle |
| 12 | Durchkontaktierung | 25 | Freistellungen |
| 13 | Durchkontaktierung | 26 | Zelle |
| 14 | Durchkontaktierung | | |

## Patentansprüche

1. Leiterplatte (1) mit einem Schichtaufbau, der zumindest eine erste und eine zweiten metallische Schicht (2, 3, 4, 5) sowie metallische Schichten trennende Lagen (6, 7, 8) aus einem isolierenden Verbundwerkstoff aufweist und mit mehreren metallischen Durchkontaktierungen (11..16) zwischen zumindest einer ersten und zumindest einer zweiten metallischen Schicht,
**dadurch gekennzeichnet, dass**
an zumindest einer Stelle der Leiterplatte (1) eine zentrale, durch zumindest eine Lage (7) verlaufende hülsenförmige Durchkontaktierung (17) vorgesehen ist, welche beidseitig an einer oberen und/oder unteren Endlage aus Verbundwerkstoff endet und deren zylindrischer Hohlraum (17h) mit Verbundwerkstoff gefüllt ist und
an zumindest einem Ende der zentralen Durchkontaktierung in Abstand (d) von dieser zumindest zwei massive, bezüglich der zentralen hülsenförmige Durchkontaktierung (17) rotationssymmetrisch verlaufende Durchkontaktierungen (18, 19) vorgesehen sind, welche mit der zentralen Durchkontaktierung in deren Endbereich in metallischer Verbindung stehen, durch eine Endlage aus Verbundwerkstoff verlaufen und bis zu einer metallischen Schicht (2; 2,5) an einer Oberfläche der Leiterplatte führen.

2. Leiterplatte nach Anspruch 1, **dadurch gekennzeichnet, dass** die massiven Durchkontaktierungen (18) an beiden Enden der zentralen hülsenförmigen Durchkontaktierung (17) vorgesehen sind und sowohl an der Oberseite als auch an der Unterseite der Leiterplatte (1) durch eine Endlage (6, 8) aus Verbundwerkstoff verlaufen.

3. Leiterplatte nach Anspruch 2, **dadurch gekennzeichnet, dass** die Anordnung der Durchkontaktierungen (17,18) bezüglich einer Mittenebene (ε) der Leiterplatte symmetrisch ist.

4. Leiterplatte nach einem der Ansprüche 1 bis 3, **dadurch gekennzeichnet, dass** die die massiven Durchkontaktierungen (18) von außen nach innen konisch verjüngt verlaufen.

5. Leiterplatte nach einem der Ansprüche 1 bis 4, **dadurch gekennzeichnet, dass** der Durchmesser der massiven Durchkontaktierungen (18) ein Drittel bis ein Fünftel des Durchmessers der zentralen Durchkontaktierung beträgt.

6. Leiterplatte nach einem der Ansprüche 1 bis 5, **dadurch gekennzeichnet, dass** der Verbundwerkstoff FR4 ist.

7. Leiterplatte nach einem der Ansprüche 1 bis 6, **dadurch gekennzeichnet, dass** das Metall für die Durchkontaktierungen Kupfer ist.

8. Leiterplatte nach Anspruch 7, **dadurch gekennzeichnet, dass** die zumindest zwei massiven Durchkontaktierungen (18) aus Kupfer bestehen.

9. Leiterplatte nach einem der Ansprüche 1 bis 8, **dadurch gekennzeichnet, dass** die gegenseitigen Abstände der Durchkontaktierungen (17, 18) so gewählt sind, dass benachbarte zentrale Durchkontaktierungen (17) jeweils massive Durchkontaktierungen (18) gemeinsam haben.
